# EUROPEAN PATENT APPLICATION

(11) **EP 2 423 349 A1**
(43) Date of publication of application: **29.02.2012**
(21) Application number: 10767084.6
(22) Date of filing: 21.04.2010
(51) Int. Cl.: C23C 14/24, H01L 51/50, H05B 33/10

(54) **VAPOR DEPOSITION APPARATUS AND VAPOR DEPOSITION METHOD**

(30) Priority: 24.04.2009 JP 2009105871; 05.03.2010 JP 2010048734
(71) Applicant: Tokyo Electron Limited, Tokyo 107-6325 (JP)
(72) Inventor: ONO, Yuji, Sendai City Miyagi 981-3137 (JP); EDURA, Tomohiko, Sendai City Miyagi 981-3137 (JP); HAYASHI, Teruyuki, Sendai City Miyagi 981-3137 (JP); TAMURA, Akitake, Nirasaki City Yamanashi 407-0192 (JP); SAITO, Misako, Nirasaki City Yamanashi 407-0192 (JP); KUWADA, Hirotaka, Sendai City Miyagi 981-3137 (JP); OTSUKI, Shimon, Sendai City Miyagi 981-3137 (JP)
(74) Representative: Manitz, Gerhart
(86) International application number: PCT/JP2010/057058
(87) International publication number: WO 2010/123027

(57) **Abstract**

There is provided a vapor deposition apparatus and a vapor deposition method capable of efficiently sublimating/melting a granular organic material with high mobility. The vapor deposition apparatus for forming a thin film on a substrate by vapor deposition includes a depressurizable material supply apparatus configured to supply a material gas, and a film forming apparatus configured to form a thin film on the substrate. The material supply apparatus includes a quantity control unit configured to control a quantity of a material, and a material gas generating unit configured to vaporize the material supplied from the quantity control unit.

## Description

### [Technical Field]

The present disclosure relates to a vapor deposition apparatus and a vapor deposition method for forming a light emitting layer in a manufacturing process of, e.g., an organic EL device.

### [Background Art]

Recently, an organic EL device using electroluminescence (EL) has been developed. The organic EL device generates almost no heat and consumes less power as compared to a cathode-ray tube or the like. Further, since the organic EL device is self-luminescent, there are some advantages such as a view angle wider than that of a liquid crystal display (LCD). For these reasons, the progress of the organic EL device in the future is expected.

Most typical structure of this organic EL device includes an anode (positive electrode) layer, a light emitting layer, and a cathode (negative electrode) layer sequentially stacked on a glass substrate to form a sandwiched structure. In order to transmit light from the light emitting layer, a transparent electrode made of, e.g., ITO (Indium Tin Oxide) is used as the anode layer on the glass substrate. Such an organic EL device is generally manufactured by forming the light emitting layer and the cathode layer in sequence on the glass substrate having thereon the ITO layer (anode layer) and by additionally forming a sealing film.

In general, the light emitting layer of such an organic EL device is formed by a vapor deposition apparatus. Patent Document 1 describes a vapor deposition apparatus and a method for film formation in the manufacturing process of an organic EL device.

Further, Patent Document 2 describes a vacuum gate valve for a powder supply chamber of a vapor deposition apparatus and a vapor deposition apparatus having the vacuum gate valve.
Patent Document 1: US 2007/0098891 A1
Patent Document 2: Japanese Patent Laid-open Publication No. 2007-155005

### [Disclosure of the Invention]

### [Problems to Be Solved by the Invention]

In an organic material supply device included in the vapor deposition apparatus described in Patent Document 1, an organic material is in the form of solid granules or pallets or in the form of a solution. By vaporizing the organic material and depositing the vaporized organic material on a target object such as a substrate, a film is formed on the target object. Further, in the vapor deposition apparatus described in Patent Document 2, MgO, an example organic material, is supplied in the form of single crystals or pellets.

As described in Patent Documents 1 and 2, when the granular organic material is supplied by using an opening/closing value such as a gate valve, mobility of the organic material is improved, so that it is possible to supply the organic material efficiently into a material sublimating chamber or the like from a material supplying device without suffering clogging or the like.

However, if the granular organic material is supplied by using the opening/closing value, a supply amount of the organic material may vary depending on various factors such as a size of the granules, a period of opening/closing time of the opening/closing valve, or the like. Moreover, a sublimation speed or melting speed may vary depending on the size of the granules of the supplied organic material, resulting in a nonuniform film forming rate. Furthermore, as compared to an organic material in the form of, e.g., powder, the sublimation rate or melting rate of the granular organic material may be lower. As a result, an operation efficiency of the vapor deposition apparatus is decreased. Meanwhile, if the organic material in the form of powder is supplied from the material supplying device into the material melting chamber, mobility of the powdery organic material is deteriorated. Also, there is a concern that a supply pipe of the material supply device is clogged with the powdery organic material, or the powdery organic material adheres to a seal surface of the opening/closing valve, so that problems such as deterioration of airtightness are caused.

The present disclosure provides a vapor deposition apparatus and a vapor deposition method capable of efficiently sublimating/melting a granular organic material at a uniform rate with high mobility.

### [Means for Solving the Problems]

In accordance with one aspect of the present disclosure, there is provided a vapor deposition apparatus for forming a thin film on a substrate by vapor deposition. The apparatus may include a depressurizable material supply apparatus configured to supply a material gas, and a film forming apparatus configured to form a thin film on the substrate. The material supply apparatus may include a quantity control unit configured to control a quantity of a material, and a material gas generating unit configured to vaporize the material supplied from the quantity control unit.

The quantity control unit may include a cover body having a cone shape tapering to a top of the cover body; a cone-shaped concave body positioned so as to face a top surface of the cover body; and a rotating device configured to rotate the cover body relative to the concave body. A side surface of the cover body may include an upper side surface and a lower side surface, and an inclination of the upper side surface is smaller than an inclination of the lower side surface. Further, the quantity control unit may include an evacuable material supply device configured to supply the material into the quantity control unit, and an elevating device configured to vary a gap between the cover body and the concave body. Furthermore, the vapor deposition apparatus may further include a vibrating device configured to vibrate the quantity control unit and a vicinity of the quantity control unit.

The material supply apparatus may further include a mixing unit having a mixing member for mixing granular materials, and the mixing unit may be provided above the quantity control unit. The material gas generation unit may be configured as a material sublimating chamber for sublimating the material therein. The material sublimating chamber may communicate with the quantity control unit via a passage having a preset length. The passage and the material sublimating chamber may include a heater, and a temperature of the passage at the side of the quantity control unit may be lower than a temperature of the passage at the side of the material gas generation unit. A sealed space accommodating the heater therein may be formed at outer surfaces of the passage and the material sublimating chamber. Moreover, a volatile liquid may be provided within the sealed space. The material sublimating chamber may include a material dispersing plate for dispersing the material by allowing the material to pass therethrough, and a material sublimating member, made of porous ceramic, having thereon a protrusion. Further, the material sublimating chamber may include a material sublimating plate for sublimating the material by heating the material; a rotatable shaft inserted through the inside of the passage; and a material dispersing device fixed to an end of the shaft and positioned in a vicinity of a top surface of the material sublimating plate. Here, inner surfaces of the passage and the material sublimating chamber may have roughness.

The material gas generation unit may be configured as a material melting chamber for melting the material therein. The material melting chamber may communicate with the quantity control unit via a passage having a preset length. The passage and the material melting chamber may include a heater, and a temperature of the passage at the side of the quantity control unit may be lower than a temperature of the passage at the side of the material gas generation unit. A sealed space accommodating the heater therein may be formed at outer surfaces of the passage and the material melting chamber, and a volatile liquid may be provided within the sealed space. Inner surfaces of the passage and the material melting chamber may have roughness.

The film forming apparatus may include a processing chamber connected with an external vacuum pump; a substrate holding chamber for holding a substrate therein; and a vapor deposition head connected with the material gas generation unit via a material inlet path. A valve for controlling a flow rate of the material may be provided at the material inlet path. A material retreating path, connected with the external vacuum pump and having an opening/closing valve may be provided at the material inlet path. A discharge path connected with the external vacuum pump, having an opening/closing vale may be provided at the vapor deposition head.

The material supply device may include an evacuable material receiving unit configured to receive the material; and a material supply unit configured to supply the introduced material into the material supply apparatus. The material receiving unit and the material supply unit may be connected with each other via a gate valve. The material receiving unit may have a refining device for refining the material. An argon gas as a carrier gas may be introduced into the quantity control unit and the material gas generation unit.

In accordance with another aspect of the present disclosure, there is provided a material supply apparatus for supplying a material gas into a film forming apparatus for forming a thin film on a substrate. The material supply apparatus may include a quantity control unit configured to quantify a material, and a material gas generating unit configured to vaporize the material supplied from the quantity control unit.

The quantity control unit may include a cover body having a cone shape tapering to a top of the cover body; a cone-shaped concave body positioned so as to face a top surface of the cover body; and a rotating device configured to rotate the cover body relative to the concave body. The quantity control unit may include an evacuable material supply device configured to supply the material into the quantity control unit, and an elevating device configured to vary a gap between the cover body and the concave body.

The material supply apparatus may further include a vibrating device configured to vibrate the quantity control unit and a vicinity of the quantity control unit. Further, the material supply apparatus may further include a mixing unit having a mixing member for mixing granular materials. The mixing unit may be provided above the quantity control unit.

The material gas generation unit may be configured as a material sublimating chamber for sublimating the material therein. The material sublimating chamber may communicate with the quantity control unit via a passage having a preset length. The passage and the material sublimating chamber may include a heater, and a temperature of the passage at the side of the quantity control unit may be lower than a temperature of the passage at the side of the material gas generation unit. The material sublimating chamber may include a material dispersing plate for dispersing the material by allowing the material to pass therethrough, and a material sublimating member, made of porous ceramic, having thereon a protrusion. The material sublimating chamber may include a material sublimating plate for sublimating the material by heating the material; a rotatable shaft inserted through the inside of the passage; and a material dispersing device fixed to an end of the shaft and positioned in a vicinity of a top surface of the material sublimating plate. Inner surfaces of the passage and the material sublimating chamber may have roughness.

The material gas generation unit may be configured as a material melting chamber for melting the material therein. The material melting chamber may communicate with the quantity control unit via a passage having a preset length. The passage and the material melting chamber may include a heater, and a temperature of the passage at the side of the quantity control unit may be lower than a temperature of the passage at the side of the material gas generation unit. Inner surfaces of the passage and the material melting chamber may have roughness.

In accordance with still another aspect of the present disclosure, there is provided a vapor deposition method for forming a thin film on a substrate by vapor deposition. The method may include grinding a granular material; vaporizing the ground material by sublimating or melting the ground material and vaporizing the melted material; and forming a thin film on the substrate by using a gas of the vaporized material. The granular material may be made by making a material in the form of powder into a material in the form of granule.

### [Effect of the Invention]

In accordance with the present disclosure, it is possible to provide a vapor deposition apparatus capable of efficiently sublimating/melting an organic material with high mobility. By sublimating/melting the organic material efficiently, it is possible to shorten a film forming time for forming an organic layer on a substrate or a standby time after ending a film formation on a substrate before starting a film formation on a next substrate. Moreover, by sublimating/melting the organic material at an appropriate timing, degradation of the organic material can be prevented. In addition, since it is possible to sublimate/melt the organic material at a regular rate, a uniform vaporizing rate can be achieved.

### [Brief Description of the Drawings]

Figs. 1(a) to 1(d) are explanatory diagrams for describing a manufacturing process of an organic EL device A.
Fig. 2 is an explanatory diagram illustrating a vapor deposition apparatus 1.
Fig. 3 is an enlarged view of a material supply apparatus 30.
Fig. 4 is a schematic cross sectional view of a material sublimating bottle 80.
Fig. 5 is a schematic cross sectional view of a material melting bottle 90.
Fig. 6 is a schematic diagram of a material sublimating plate 82.
Fig. 7 is a schematic cross sectional view of a material sublimating bottle 80'.
Fig. 8 is a schematic perspective view of a material dispersing device 95.
Fig. 9 is an explanatory diagram illustrating a configuration in which sealed spaces 100 are formed at outer surfaces of the material sublimating bottle 80 and at outer surfaces of the drop passage 72 connected to a top portion of the material sublimating bottle 80.
Fig. 10 is an enlarged side view of a cover body 60' formed in a cone shape having two-level inclinations.
Fig. 11 is a graph showing a relationship between a time after the start of a material supply and a cumulative supply amount of the material.
Figs. 12(a) to 12(c) are side views illustrating modified examples of the cover body 60.
Fig. 13 is an explanatory diagram illustrating an example configuration of a material supply device 40.

### [Explanation of Codes]

- 1:: Vapor deposition apparatus
- 10:: Anode layer
- 11:: Light emitting layer
- 12:: Cathode layer
- 13:: Sealing film layer
- 15:: Film forming apparatus
- 20:: Processing chamber
- 21:: Substrate holding chamber
- 22:: Vapor deposition head
- 26,: 55: Vacuum pump
- 30:: Material supply apparatus
- 30a:: Control unit
- 30b:: Supply unit
- 30c:: Material gas generation unit
- 31:: Material inlet path
- 33:: Elastic seal main body
- 40:: Material supply device
- 41:: Mixing member
- 42:: Mixing unit
- 43:: Drop hole
- 44:: Rotary body
- 50,: 62: Rotating device
- 51:: Rotation transmission unit
- 52:: Heater
- 57:: Gas introducing device
- 60,: 60': Cover body
- 61:: Shaft
- 63:: Concave body
- 64:: Gap
- 65:: Elevating device
- 66:: Measuring device
- 70:: Quantity control unit
- 71:: Space
- 72:: Drop passage
- 80,: 80': Material sublimating bottle
- 81:: Material dispersing plate
- 82:: Material sublimating plate
- 82':: Protrusion
- 90:: Material melting bottle
- 91:: Gas through hole
- 92:: Partition plate
- 95:: Material dispersing device
- 96:: Material distributing body
- 97:: Material uniformizing body
- 98:: Material melting plate
- 100:: Sealed space
- 101:: Side surface
- 101a:: Gently inclined surface
- 101b:: Sharply inclined surface
- 103:: Boundary
- 104:: Cone-shaped member
- 105:: Cylinder-shaped member
- 120:: Material receiving unit
- 121:: Exhaust port
- 130:: Gate valve
- 132:: Space
- 133:: Inlet opening
- 140:: Refining device
- 142:: Heater
- 145:: Mixing device
- 147:: Rotation shaft
- 149:: Mixing rod
- 150:: Duct
- A:: Organic EL device
- B:: Liquefied organic material
- G:: Substrate
- L:: Liquid

### [Best Mode for Carrying out the Invention]

Hereinafter, embodiments of the present disclosure will be described with reference to the accompanying drawings. Through the present specification and drawings, like parts having substantially the same function and configuration will be assigned like reference numerals, and redundant description thereof will be omitted.

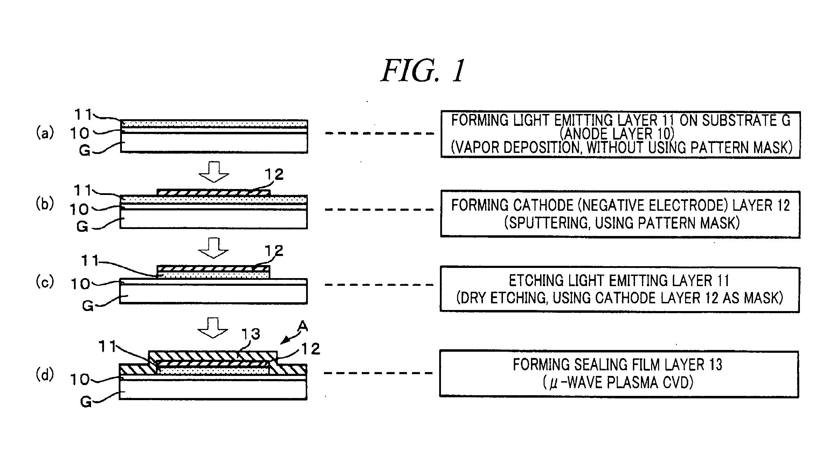

Figs. 1(a) to 1(d) are explanatory diagrams for describing a manufacturing process of an organic EL device A manufactured by various kinds of film forming apparatuses including a vapor deposition apparatus 1 in accordance with an embodiment of the present disclosure. As depicted in Fig. 1(a), a substrate G having thereon an anode (positive electrode) layer 10 may be provided. The substrate G may be made of a transparent material such as glass. The anode layer 10 may be made of a transparent conductive material such as ITO (Indium Tin Oxide). Further, the anode layer 10 may be formed on an upper surface of the substrate G by, e.g., a sputtering method or the like.

First, as depicted in Fig. 1(a), a light emitting layer (organic layer) 11 may be formed on the anode layer 10 by vapor deposition. Further, the light emitting layer 11 may have a multi-layered structure in which, for example, a hole transport layer, a non-light emitting layer (electron blocking layer), a blue light emitting layer, a red light emitting layer, a green light emitting layer, and an electron transport layer are layered.

Then, as depicted in Fig. 1(b), a cathode (negative electrode) layer 12 made of, e.g., Ag, Al or the like may be formed on the light emitting layer 11 by, e.g., sputtering using a mask.

Subsequently, as depicted in Fig. 1(c), the light emitting layer 11 may be, for example, dry-etched by using the cathode layer 12 as a mask, so that the light emitting layer 11 may be patterned.

Thereafter, as depicted in Fig. 1(d), an insulating sealing layer 13 made of, e.g., silicon nitride (SiN) may be formed so as to cover the light emitting layer 11, the cathode layer 12, and an exposed portion of the anode layer 10. The sealing layer 13 may be formed by, for example, a µ-wave plasma CVD method.

In the organic EL device A manufactured as described above, the light emitting layer 11 may emit light by applying a voltage between the anode layer 10 and the cathode layer 12. This organic EL device A may be applied to a display device or a surface emitting device (illumination, light source or the like) and can be used for various other electronic devices.

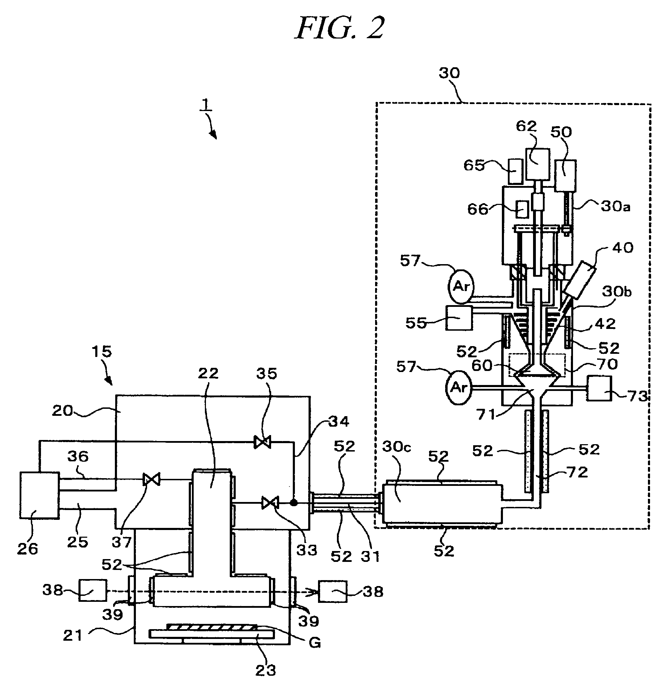

Fig. 2 is a schematic explanatory diagram illustrating the vapor deposition apparatus 1 in accordance with the embodiment of the present disclosure. In a typical vapor deposition apparatus, a multiple number of vapor deposition heads, each for discharging a gas of an organic material to a substrate G, are provided so as to deposit a multiple number of organic layers such as, but not limited to, a hole transport layer, a non-light emitting layer (electron blocking layer), a blue light emitting layer, a red light emitting layer, a green light emitting layer, and an electron transport layer. In the present embodiment, however, an example configuration with a single vapor deposition head will be described as below with reference to the accompanying drawings.

The vapor deposition apparatus 1 shown in Fig. 2 may include a film forming apparatus 15 for forming a thin film on the substrate G and a material supply apparatus 30 for supplying a material gas for the film formation into the film forming apparatus 15. Provided within the film forming apparatus 15 are a processing chamber 20 for performing the film formation therein and a substrate holding chamber 21. A vapor deposition head 22 may be provided within the film forming apparatus 15 to be extended over the processing chamber 20 and the substrate holding chamber 21. The substrate holding chamber 21 may be located under the processing chamber 20. Within the substrate holding chamber 21, a holding table 23 for holding thereon the substrate G may be provided. The substrate G is mounted on the holding table 23 such that the substrate G's upper surface on which a film is formed faces upwards (face-up state). Here, the vapor deposition head 22 may be positioned such that a material gas discharging surface thereof faces the upper surface (target surface for film formation) of the substrate G. Further, the processing chamber 20 may be connected with a vacuum pump 26 via a gas exhaust pipe 25. The processing chamber 20 may be evacuated to vacuum when the film forming process is performed.

The material supply apparatus 30 may include a control unit 30a, a supply unit 30b and a material gas generation unit 30c. The vapor deposition head 22 may be connected with the material gas generation unit 30c of the material supply apparatus 30 via a material inlet path 31 for introducing the material gas into the vapor deposition head 22. That is, the material gas supplied from the material gas generation unit 30c may be introduced into the vapor deposition head 22 and then be discharged toward the substrate G from the vapor deposition head 22. Further, the material inlet path 31 may be provided with a valve 33 for controlling introduction of the material gas into the vapor deposition head 22. A material retreating path 34 communicating with the vacuum pump 26 and having an opening/closing valve 35 may be provided at the material inlet path 31 between the material gas generation unit 30c and the valve 33. Further, the vapor deposition head 22 may be connected with a discharge path 36 communicating with the vacuum pump 26 and having an opening/closing valve 37.

Moreover, windows 39 that transmit light may be formed at both lateral sides of the vapor deposition head 22 and both lateral sides of the substrate holding chamber 21. A vapor amount measuring device 38 may be provided outside the substrate holding chamber 21. By transmitting light through the windows 39, the vapor amount measuring device 38 is capable of measuring a vapor amount of the material gas within the vapor deposition head 22 by, e.g., Fourier Transform Infrared Spectroscopy (FTIR).

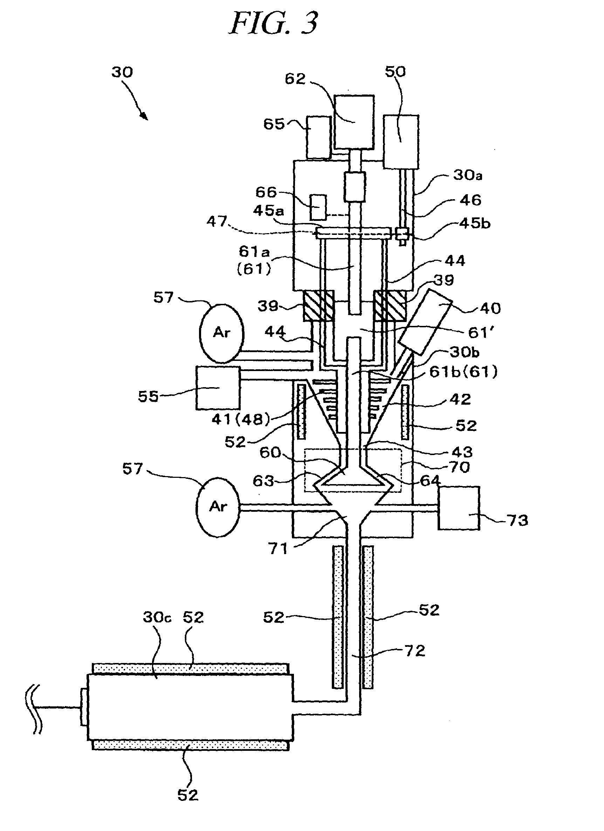

Now, a configuration of the material supply apparatus 30 will be explained with reference to Fig. 2 and Fig. 3. Fig. 3 is an enlarged view of the material supply apparatus 30 of Fig. 2. As shown in Fig. 3, the material supply apparatus 30 may include the control unit 30a, the supply unit 30b, and the material gas generation unit 30c. The control unit 30a and the supply unit 30b may be connected with each other via an extensible/contractible elastic sealing member 39. In the material supply apparatus 30, a material supply device 40 of, e.g., a load lock type for supplying an organic material may be provided. The organic material in the form of granules may be supplied from the material supply device 40 into a mixing unit 42 having a mixing member 41. As illustrated in Fig. 3, the mixing unit 42 may have a cone shape tapering to a bottom of the mixing unit 42. A drop hole 43 through which the organic material falls down may be provided at a bottommost portion of the mixing unit 42. The mixing member 41 may be provided at a center of the mixing unit 42. Here, the mixing member 41 may be connected with a rotary body 44 provided within the material supply apparatus 30. A pulley 45a may be provided at an upper portion of the rotary body 44. Further, under a rotating device 50 provided at a top portion of the control unit 30a, a pulley 45b may be provided via a rotation shaft 46. A belt 47 may be connected between the pulleys 45a and 45b, and a rotational force of the rotating device 50 may be transferred to the rotary body 44, so that the mixing member 41 may be rotated within the mixing unit 42. Further, the mixing member 41 may include a multiple number of rod-shaped members 48 provided to the periphery of the rotary body 44. In this configuration, the organic material supplied into the mixing unit 42 may be mixed by the rod-shaped members 48 as the mixing member 41 is rotated.

A Heater 52 may be provided on both lateral sides of the mixing unit 42 so as to control a temperature of the mixing unit 42. Further, the mixing unit 42 may be sealed against an upper portion (control unit 30a) of the material supply apparatus 30 by the elastic sealing member 39. The interior of the mixing unit 42 may be evacuated by a vacuum pump 55 and a carrier gas such as argon gas may be introduced into the mixing unit 42 by a gas introducing device 57.

Provided under the mixing unit 42 is a cover body 60, having a cone shape tapering to a top of the cover body 60, for blocking up the drop hole 43 from below. The cover body 60 may be supported by a shaft 61 provided at a top portion of the cover body 60. The shaft 61 may include an upper shaft 61a and a lower shaft 61b connected by a coupling member 61'. A rotating device 62 such as a rotating motor may be connected to a top portion of the shaft 61a. The shaft 61 may be configured to be rotatable. That is, the cover body 60 supported at the shaft 61 may also be configured to be rotatable. Further, an elevating device 65 may be provided above the control unit 30a. The elevating device 65 may vertically move the control unit 30a including the rotating device 62, the shaft 61, and the cover body 60 supported at the shaft 61. Here, since the control unit 30a may be moved up and down by the elevating device 65, a moving distance by the elevating device 65 may be measured by a measuring device 66 such as a micrometer provided to the control unit 30a.

In the vicinity of an upper portion of the cover body 60, a concave body 63 having a cone shape may be provided so as to face a top surface of the cover body 60. As the cover body 60 is moved up and down, the width of a gap 64 between the cover body 60 and the concave body 63 may be varied. That is, a variation in the width of the gap 64 may be measured by the measuring device 66. In the following, the structure of a quantity control unit 70 will be explained. The structure includes the cover body 60 and the concave body 63, and the cover body 60 is rotated and moved up and down by the rotating and elevating devices, and the width of the gap 64 is varied.

A space 71 having a cone shape tapering to a bottom of the space 71 may be formed under the quantity control unit 70. Further, a drop passage 72 through which the organic material falls down may be provided at a lower portion of the space 71. The space 71 may be connected with the gas introducing device 57. By way of example, an argon gas as the carrier gas may be introduced and a pressure of the argon gas may be measured by a pressure gauge 73. Further, a heater 52 may be provided at both lateral sides of the drop passage 72 so as to control a temperature of the drop passage 72. Here, desirably, the drop passage 72 may have a temperature gradient such that a temperature at the side of the quantity control unit 70 is lower than a temperature at the side of the material gas generation unit 30c.

As shown in Fig. 2, the drop passage 72 may communicate with the material gas generation unit 30c. Here, the material gas generation unit 30c may include a heater 52. The organic material may be liquefied or vaporized in the material gas generation unit 30c. The drop passage 72 is a passageway for dropping the organic material. The length of the drop passage 72 may be set to be longer than a certain length so as to avoid a backflow of an organic material gas vaporized in the material gas generation unit 30c.

In the material gas generation unit 30c, the organic material may be liquefied or vaporized. Here, the organic material may be a sublimating material such as Alq₃ or a melting material such as α-NPD. Since vaporization mechanisms of the sublimating material and the melting material are different, it is desirable that configuration of the material gas generation unit 30c is largely different between cases of using the sublimating material and the melting material in order to vaporize the materials efficiently.

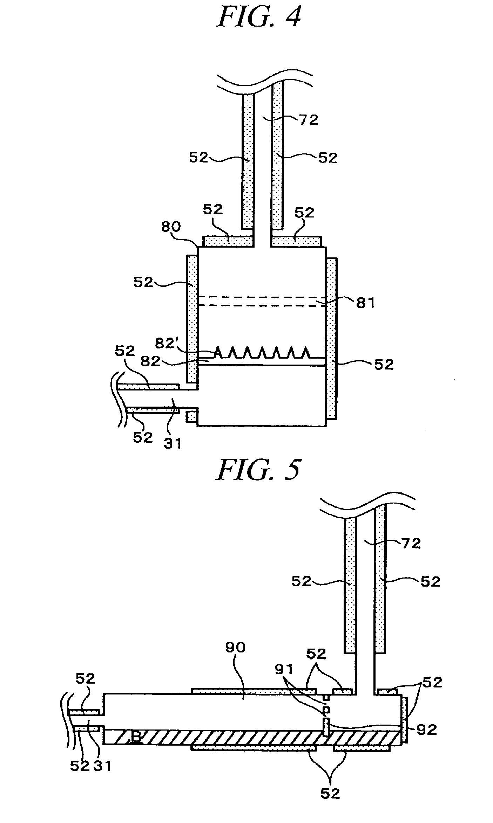

Illustrated in Fig. 4 is a configuration in which a material sublimating bottle 80 is provided as the material gas generation unit 30c when the organic material is a sublimating material. Further, illustrated in Fig. 5 is a configuration in which a material melting bottle 90 is provided as the material gas generation unit 30c when the organic material is a melting material.

Fig. 4 is a schematic cross sectional view of the material sublimating bottle 80 configured to generate a material gas by sublimating an organic material when the organic material supplied from the material supply apparatus 30 is a sublimating material. As shown in Fig. 4, an outlet of the drop passage 72 may be formed at an upper portion of the material sublimating bottle 80, and the material inlet path 31 communicating with the vapor deposition head 22 within the processing chamber 20 may be formed at a lower portion of the material sublimating bottle 80. Further, a material dispersing plate 81 having, e.g., a mesh shape may be provided in an upper space within the material sublimating bottle 80. Further, a material sublimating plate 82 made of, e.g., porous ceramic may be provided below the material dispersing plate 81 and above the material inlet path 31. Here, the material sublimating plate 82 may have thereon a multiple number of protrusions 82'. The material sublimating plate 82 may have a larger surface area than that of a material sublimating plate with a typical flat plate shape. Moreover, the heater 52 may be provided at both lateral sides of the drop passage 72 and the material inlet path 31 as described above. Further, a heater 52 may be also provided on an upper surface and both lateral sides of the material sublimating bottle 80 so that a temperature can be controlled. Here, in order to sublimate the organic material stably and efficiently, it may be desirable that the temperature of the material sublimating bottle 80 may be uniformized within a temperature range of about ± 0.2°C, more desirably, within a temperature range of about ± 0.1°C.

Fig. 5 is a schematic cross sectional view of the material melting bottle 90 configured to generate a material gas by melting an organic material when the organic material supplied from the material supply apparatus 30 is a melting material. As depicted in Fig. 5, above one end portion of the material melting bottle 90, an outlet of the drop passage 72 communicating with the material supply apparatus 30 may be formed. The other end portion may be connected to the material inlet path 31 communicating with the vapor deposition head 22 within the processing chamber 20. Further, a partition plate 92 including multiple gas through holes 91 may be provided adjacent to the outlet of the drop passage 72 within the material melting bottle 90. Herein, the partition plate 92 may not fully divide an inner space of the material melting bottle 90 as depicted in Fig. 5. That is, the partition plate 92 may not reach a lower surface of the inner space of the material melting bottle 90. Therefore, a lower portion of the material melting bottle 90 may not be divided. Further, a melting material B generated by liquefying the organic material may be provided in a certain amount so as not to block the gas through holes 91 and the material inlet path 31 as depicted in Fig. 5. That is, the gas through holes 91 may be formed above a liquid surface of the melting material B. Further, in the same manner as the material sublimating bottle 80, the heater 52 may be provided on an upper surface, a lower surface, and a side surface of the material melting bottle 90 so that a temperature can be controlled.

In the vapor deposition apparatus 1 explained with reference to Figs. 2 and 3, if an organic layer is formed by vapor deposition in order to form the light emitting layer on the substrate G as shown in Fig. 1(a), a granular organic material may be supplied into the mixing unit 42 from the material supply device 40. Herein, the mixing unit 42 can be evacuated by the vacuum pump 55 communicating therewith, and an argon gas as a carrier gas may be supplied from the gas introducing device 57. The granular organic material supplied into the mixing unit 42 may be mixed uniformly by the mixing member 41 configured to be rotated by the rotating device 50. In the mixing unit 42, the organic material may be heated by the heater 52 provided at side surfaces of the mixing unit 42. Moreover, since the mixing unit 42 can be evacuated, impurities, such as water, other than the organic material may be removed and refined.

Then, the mixed granular organic material may fall down from the drop hole 43 to the gap 64 between the cover body 60 and the concave body 63 of the quantity control unit 70. Herein, a width of the gap 64 is smaller than a diameter of the granular organic material. The cover body 60 is supported by the shaft 61 from above. Since the shaft 61 may be rotated by the rotating device 62, the cover body 60 may also be rotated accordingly. For this reason, the granular organic material fallen down to the gap 64 may be rotated in the gap 64 to be ground into the powder in the same manner as in a mortar and pestle. Since a lower circumference velocity during the rotation of the cover body 60 is faster than an upper circumference velocity, the organic material ground into powder may slowly fall down along an upper surface of the cover body 60 toward an outside thereof. Then, the organic material may fall down to the space 71 formed in a lower region of the quantity control unit 70.

As the shaft 61 is moved up and down by the elevating device 65, the cover body 60 may also be moved up and down accordingly. A distance moving up and down may be measured by the measuring device 66. Therefore, the width of the gap 64 can be easily changed by moving the cover body 60 up and down, and the width of the gap 64 can be measured by the measuring device 66. As described above, the argon gas as a carrier gas may be supplied into the mixing unit 42 from the gas introducing device 57. In the same manner, the carrier gas may be introduced into the quantity control unit 70 and the space 71. A difference in the carrier gas pressure between the mixing unit 42 and the space 71 may be one of causes allowing the powdery organic material to fall down from the quantity control unit 70.

That is, if a sufficient amount of organic material is supplied by the material supply device 40, the amount of the organic material falling down from the mixing unit 42 to the space 71 may be determined depending on three factors of the width of the gap 64, the rotation speed of the cover body 60 and a pressure difference between the mixing unit 42 and the space 71. These three factors can be controlled by the elevating device 65, the rotating device 50, and the gas introducing device 57. Therefore, it may be possible to control the amount of powdery organic material falling from the quantity control unit 70 to be a desired level. The pressure difference between the mixing unit 42 and the space 71 can be removed by controlling a pressure of a carrier gas to be supplied to each of the mixing unit 42 and the space 71 to be the same. As a result, the amount of the falling organic material can be determined only under control of the elevating device 65 and the rotating device 50 of the control unit 30a. Thus, it may be possible to supply the organic material into the material gas generation unit 32 more easily.

Then, a desired amount of the refined powdery organic material may pass through the drop passage 72 from the space 71, and may be introduced into the material gas generation unit 30c. Herein, the material gas generation unit 30c may have different configurations depending on whether an introduced organic material is a sublimating material or a melting material. The configurations have been explained above by reference to Figs. 4 and 5. Hereinafter, there will be explained a case where the organic material is a sublimating material and a case where the organic material is a melting material by reference to Figs. 4 and 5.

If the organic material is a sublimating material, the material sublimating bottle 80 depicted in Fig. 4 may be used. The powdery organic material falling down from the drop passage 72 to the material sublimating bottle 80 may be dispersed through, for example, the mesh-shaped material dispersing plate 81. Then, the powdery organic material may be accumulated on an upper surface of the material sublimating plate 82 made of, for example, porous ceramic. The material sublimating plate 82 may be maintained at a temperature higher than a sublimation temperature of the organic material (sublimating material) by heaters. The organic material deposited on the material sublimating plate 82 may be sublimated to be a material gas. Since the organic material is deposited on the material sublimating plate 82 in the form of powder, the organic material can be efficiently sublimated in a very short time as compared with a case, for example, where a granular organic material is sublimated. Further, a great amount of material gas can be generated. The generated material gas may be pushed out by a carrier gas introduced into the material sublimating bottle 80 from the drop passage 72, and be discharged from the material inlet path 31.

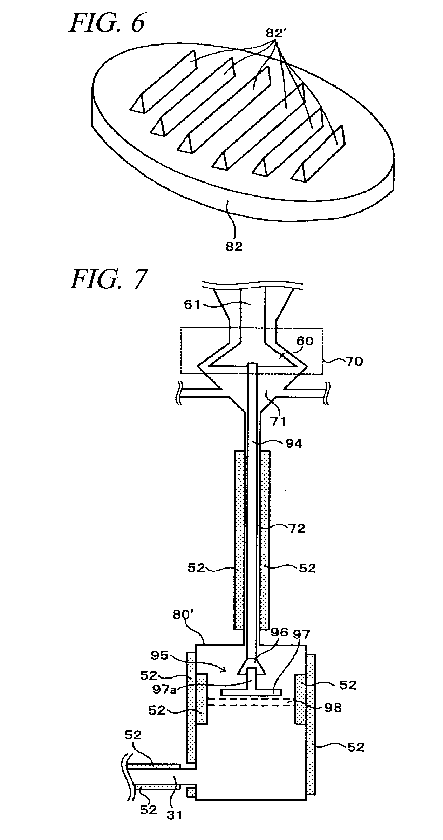

The material sublimating plate 82 may be configured to efficiently heat the accumulated powdery organic material to be sublimated. Desirably, by way of example, as depicted in Fig. 6, the material sublimating plate 82 may have thereon multiple protrusions 82'. Further, the material sublimating plate 82 may be made of equi-thermal material capable of equally heating the accumulated powdery organic material. By way of example, the material sublimating plate 82 may be made of porous ceramic.

If the organic material is a melting material, the material melting bottle 90 depicted in Fig. 5 may be used. Since the inside of the material melting bottle 90 is maintained at a temperature higher than a melting point, the powdery organic material falling down from the drop passage 72 to the material melting bottle 90 may be liquefied. As a result, a liquefied organic material B is provided in a lower portion of the material melting bottle 90 as depicted in Fig. 5. In the material melting bottle 90, as described above, the lower portion thereof is not partitioned by the partition plate 92. The partition plate 92 having two gas though holes 91 may be provided only at an upper portion thereof.

Since the liquefied organic material B may be constantly heated by the heater 52 provided on the material melting bottle 90, it may be vaporized within the material melting bottle 90, and the material melting bottle 90 may be full of a material gas. Since a carrier gas flows from the drop passage 72 to the material melting bottle 90, the material gas may be discharged from the material inlet path 31. The material inlet path 31 is formed at a portion facing a position where the drop passage 72 of the material melting bottle 90 is formed.

As described above, the material gas vaporized from the organic material may be introduced from the material gas generation unit 30c of the material sublimating bottle 80 or the material melting bottle 90 into the material gas inlet path 31. As depicted in Fig. 2, since the material inlet path 31 communicates with the vapor deposition head 22 within the processing chamber 20, when the valve 33 is opened, the material gas may be introduced into the vapor deposition head 22. Since the heater 52 may be provided on the vapor deposition head 22, the material gas may not be solidified within the vapor deposition head 22. The material gas may be discharged from the vapor deposition head 22 toward the substrate G.

When the material gas is not discharged from the vapor deposition head 22 toward the substrate G, the valve 33 may be closed. Thus, the material gas may not be introduced into the vapor deposition head 22 from the material inlet path 31. In this case, the material gas may remain in the material gas inlet path 31. However, since the material gas inlet path 31 includes the valve 35 and the material retreating path 34 communicating with the vacuum pump 26, the material gas may be sucked/exhausted by the vacuum pump 26. The vapor deposition head 22 may include the discharge path 36, communicating with the vacuum pump 26, for sucking/exhausting the material gas remaining in the vapor deposition head 22 and for evacuating the inside of the vapor deposition head 22. Through the material retreating path 34 and the discharge path 36, the material gas remaining in the material inlet path 31 and the vapor deposition head 22 can be completely exhausted. Therefore, if a film is formed on multiple substrates G, the film can be formed on each substrate G in a uniform film forming environment and a highly uniform film formation on each substrate G can be performed.

A reference amount of material gas may be compared with an actual amount of material gas within the vapor deposition head 22 measured by a vapor amount measuring device 38, such as a FTIR detector. The FTIR detector may be provided at a side surface of the vapor deposition head 22 (at a side surface of a substrate holding chamber 21). Thereafter, a comparison result may be sent as signals to the heater 52 provided on the gas introducing device 57 of the material supply apparatus 30 or on each component. Based on these signals, the amount of a carrier gas introduced from the gas introducing device 57 or a temperature of each component may be controlled so as to optimize the amount of material gas within the vapor deposition head 22.

In accordance with the vapor deposition apparatus of the present embodiment described above, by controlling the amount of the granular organic material in the material supply apparatus 30 and by making the granular organic material into powder, it may be possible to efficiently vaporize the organic material so as to generate the material gas. Further, when the material gas is deposited on the substrate G to form a film by deposition, a film is formed on a first substrate G, and then the insides of the vapor deposition head 22 and the material inlet path 31 is evacuated. Then, a film is formed on a next substrate G under substantially the same conditions as the first substrate G. In this way, a film can be formed uniformly on each substrate G.

By way of example, if a granular material is supplied to the quantity control unit 70 with the load-lock type material supply device 40, the amount of the material at the time of being supplied can be controlled accurately and the material can be continuously supplied as compared with a case where a powdery material is used.

The embodiment of the present disclosure has been explained above, but the present disclosure is not limited thereto. It would be understood by those skilled in the art that various changes and modifications may be made in the scope of the accompanying claims and their equivalents are included in the scope of the present disclosure.

In the above-described embodiment, there has been explained a case where an organic EL device is manufactured and an organic layer is deposited on a substrate with an organic material, but the present disclosure is not limited thereto. The present disclosure may be applied to various electronic devices and optical devices manufactured by performing a film forming process and a surface treatment by vapor deposition.

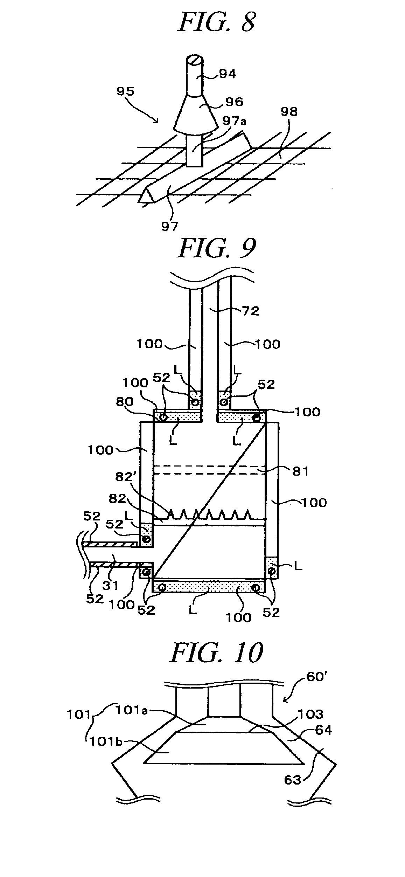

Further, in the above-described embodiment, there has been explained a case where if an organic material supplied from the material supply apparatus 30 depicted in Fig. 2 or Fig. 3 is a sublimating material, the material sublimating bottle 80 has a configuration as depicted in Fig. 4, but the present disclosure is not limited thereto. Hereinafter, there will be explained a material sublimating bottle 80' having a different configuration with reference to Figs. 7 and 8. Like reference numerals will be given to elements corresponding to those described in the embodiment, and redundant description thereof will be omitted.

As depicted in Fig. 7, within the material sublimating bottle 80', a shaft 94 may be provided in a drop passage 72. An upper end of the shaft 94 may be connected to the cover body 60, and the shaft 94 may be rotated with the cover body 60 in the drop passage 72. Further, as depicted in Fig. 8, at a lower end of the shaft 94 within the material sublimating bottle 80', a material distributing body 96 and a material uniformizing body 97 may be provided as a material dispersing device 95. The material distributing body 96 may have a cone shape tapering to a top of the material distributing body 96. The material uniformizing body 97 may be horizontally provided below the material distributing body 96 via a rotation shaft 97a. By way of example, within the material sublimating bottle 80', a mesh-shaped material sublimating plate 98 may be provided below the material uniformizing body 97. The material sublimating plate 98 may be heated by a heater 52 provided at the material sublimating plate 98. The material uniformizing body 97 may be formed in a rod shape having a triangular cross section. A bottom surface of the material uniformizing body 97 may be placed in parallel with a top surface of the material sublimating plate 98 at a certain gap.

As described in the above embodiment, the cover body 60 may be rotated by a movement of the rotating device 62. For this reason, the shaft 94 connected to the cover body 60 may be rotated, and the material distributing body 96 and the material uniformizing body 97 may also be rotated in connection with the shaft 94.

In the material sublimating bottle 80' configured as described above, after falling down from the material supply apparatus 30 through a drop passage 72 by means of a flow of a carrier gas, a powdery organic material serving as a sublimating material may be distributed widely on the material sublimating plate 98 by the rotating material distributing body 96. The powdery organic material distributed on the material sublimating plate 98 may be dispersed uniformly on the material sublimating plate 98 by the rotation of the material uniformizing body 97. The uniformly dispersed organic material may be heated by the heated material sublimating plate 98 so as to be sublimated. The sublimated organic material (organic material gas) may be discharged from the material inlet path 31 in the same manner as the above-described embodiment.

In the above-described embodiment, there has been explained a case where the heaters 52 may be provided at the upper and the side surfaces of the material gas generation unit 30c (the material sublimating bottles 80 and 80'; and the material melting bottle 90) and the side surface of the drop passage 72. However, desirably, by way of example, these heaters 52 may be provided in sealed spaces configured to cover the entire outer surfaces of the material gas generation unit 30c and the drop passage 72. Therefore, there will be explained a sealed space 100 configured to cover the entire outer surfaces of the material gas generation unit 30c and the drop passage 72 with reference to Fig. 9. Although there will be explained a case where the material sublimating bottle 80 may be used as the material gas generation unit 30c, the sealed space 100 can be formed on the outer surface of the material gas generation unit 30c even if the material gas generation unit 30c has a different configuration (the material melting bottle 90 or the material sublimating bottle 80').

Fig. 9 is an explanatory diagram showing a case where the sealed space 100 is formed on an outer surface of the material sublimating bottle 80 depicted in Fig. 4 and the drop passage 72 positioned above the material sublimating bottle 80 and communicating therewith. As depicted in Fig. 9, the sealed space 100 may be formed at the entire outer surfaces (a side surface, an upper surface, and a lower surface) of the material sublimating bottle 80 and a side surface of the drop passage 72. The sealed space 100 may be formed on each of the side surface, the upper surface, and the lower surface of the material sublimating bottle 80 or may be formed so as to cover the entire outer surface of the material sublimating bottle 80. An inside of the sealed space 100 may be sealed and a volatile liquid L may be provided therein. Further, the heater 52 may be provided so as to be immersed in the liquid L. As for the liquid L, liquids that are vaporized at a certain temperature, such as water or naphthalene, may be used. The liquid L may not need to be fully filled in each sealed space 100. It may be sufficient if the liquid L is provided in a bottom portion of the sealed space 100. The heater 52 immersed in the liquid L may have a size/length capable of sufficiently heating the liquid L and the size/length thereof can be controlled appropriately.

In the sealed space 100, the liquid L provided in the sealed space 100 may be vaporized by the heater 52, and then, may be in contact with the entire inner surface of the sealed space 100. Thus, the entire sealed space 100 can be heated. That is, the sealed space 100 may have a configuration/operation similar to a so-called "heat pipe". In this case, vapor of the liquid L in contact with an inner surface of the sealed space 100 may be cooled by heat exchange with the inner surface thereof. The vapor may be liquefied to a liquid (liquid L), and may return to the liquid L within the sealed space 100. That is, the state of the liquid L may be changed while being repeatedly vaporized and liquefied within the sealed space 100. Further, in the present modified example, a shape of the inner surface of the sealed space 100 may not be limited. The inner surface of the sealed space 100 may have a typical plane shape. However, in order for the liquid L liquefied at the inner surface of the sealed space 100 to be collected to the liquid L in the bottom portion of the sealed space more effectively, desirably, a surface area of the inner surface of the sealed space 100 may be large and may have a shape easily causing a capillary action. By way of example, the inner surface may be processed in a mesh shape or a groove shape.

In the material sublimating bottle 80 including the sealed space 100 depicted in Fig. 9, when a material is sublimated, the liquid L may be heated by the heater 52 and vaporized within the sealed space 100. The inside of the sealed space 100 may be provided with vapor at a substantially uniform temperature. Thus, the outer surface of the material sublimating bottle 80 of which the entire outer surface is covered with the sealed space 100 may be uniformly heated at a certain temperature by heat exchange with the sealed space 100. On the same operation, the side surface of the drop passage 72 may also be uniformly heated at a certain temperature. Therefore, the insides of the drop passage 72 and the material sublimating bottle 80 uniformly thermalized/heated by radiant heat from the side surface/the outer surface thereof, respectively, may be uniformly heated at a certain temperature with high accuracy. That is, by controlling a temperature of the heater 52, the temperatures of the insides of the drop passage 72 and the material sublimating bottle 80 may be controlled with high accuracy. As a result, a temperature of an organic material passing through the drop passage 72 and a temperature of an organic material sublimated within the material sublimating material bottle can be controlled with high accuracy.

Fig. 9 shows a case where the sealed space 100 including the heater 52 is formed on the outer surfaces of the material gas generation unit 30c (the material sublimating bottle 80) and the drop passage 72. However, other apparatus or paths (for example, the material inlet path 31 having the heater 52 in the present disclosure) may have the same configuration in which the heater 52 is provided in the sealed space 100.

In the above-described embodiment, there has been explained a case where a single vapor deposition head is provided. However, typically, in a vapor deposition apparatus, multiple vapor deposition heads each for discharging an organic material gas onto a substrate G may be provided to form multiple organic layers such as a hole transport layer, a non-light-emitting layer (electron blocking layer), a blue light emitting layer, a red light emitting layer, a green light emitting layer, and an electron transport layer by vapor deposition. A vapor deposition apparatus including multiple material supply units according to the number of these multiple vapor deposition heads in accordance with the present disclosure may also be included in the scope of the present disclosure.

In the above-described embodiment, by way of example, a vibrating device such as an ultrasonic vibrator may be provided in the mixing unit 42 or the space 71. Thus, if a granular or a powdery organic material is deposited/remains in the mixing unit 42 or the space 71, the deposited/remaining organic material can fall down readily by an operation of the vibrating device. Further, there has been explained a case where the vibrating device is provided in the mixing unit 42 and the space 71, but the positions thereof may not be limited thereto. The vibrating device can be provided at any position within the vapor deposition apparatus 1 if there is a possibility that the organic material may be deposited/may remain at that position.

Desirably, by way of example, the inner surface of the space 71 within the quantity control unit 70 or the inner surface of the drop passage 72 may be formed in a roughened surface instead of a mirror surface. Thus, a powdery organic material may fall down without adhering to the inner surface of the space 71 or the inner surface of the drop passage 72.

In the above-described embodiment, there has been explained that a shape of the cover body 60 serving as one of components of the quantity control unit 70 may have a cone shape tapering to the top of the cover body 60. However, the cover body 60 may have a cone shape tapering to the top of the cover body 60 with two-level inclinations. Fig. 10 is an enlarged side view of a cover body 60' having a cone shape tapering to the top of the cover body 60' with two-level inclinations. As depicted in Fig. 10, the cover body 60' may have a cone shape tapering to the top of the cover body 60'and its side surface (inclined surface) 101 may include a smoothly inclined surface 101a (upper side surface) and a sharply inclined surface 101b (lower side surface) continuously connected to each other. That is, when comparing an inclined angle of the smoothly inclined surface 101a with that of the sharply inclined surface 101b, an inclined angle of the smoothly inclined surface 101a may be relatively smaller than that of the sharply inclined surface 101b. A boundary 103 between the smoothly inclined surface 101a and the sharply inclined surface 101b may be positioned near a central portion of the side surface 101. A difference in the inclined angles; a position of the boundary 103 between the smoothly inclined surface 101a and the sharply inclined surface 101b; or specific inclined angles of the smoothly inclined surface 101a and the sharply inclined surface 101b may be appropriately determined such that the amount of an organic material controlled by the quantity control unit 70 may reach a certain level.

In the above-described embodiment, there has been explained that the powdery organic material falls down to the space 71 by the principle that the lower periphery of the cover body 60 may be faster than the upper periphery thereof. However, depending on an inclined angle of the cover body 60, all the organic material may not fall down effectively and the organic material may remain at the upper surface (side surface) of the cover body 60. If the vapor deposition apparatus 1 may be continuously operated for a long time, the organic material may remain/may adhere to the upper surface (side surface) of the cover body 60 as time passes. As a result, falling efficiency of the organic material in the quantity control unit 70 may be deteriorated after the vapor deposition apparatus is operated for a long time.

Therefore, a modified example depicted in Fig. 10 may be effective as an alternative in a case where the organic material remains/is deposited at the upper surface (side surface) of the cover body 60. That is, as depicted in Fig. 10, the cover body 60 of the quantity control unit 70 may have a configuration of the cover body 60' having a cone shape tapering to the top of the cover body 60' with two-level inclinations, so that it may be possible to reduce the organic material remaining at the side surface 101 of the cover body 60' and possible to stably control the amount of the organic material falling down to the space 71 through the gap 64 between the concave body 63 and the cover body 60'. The difference of the inclined angles; the position of the boundary 103 between the smoothly inclined surface 101a and the sharply inclined surface 101b; and the specific inclined angles of the smoothly inclined surface 101a and the sharply inclined surface 101b may be controlled to have a certain position/values. Accordingly, it may be possible to drop the organic material to the space 71 by controlling the amount of the organic material through the quantity control unit 70 with higher accuracy.

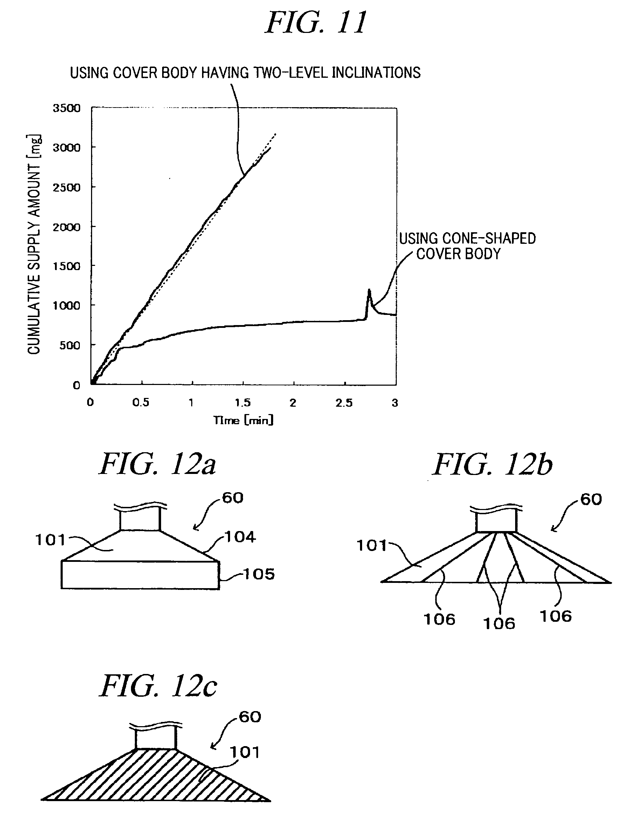

Fig. 11 is a graph showing a time after the start of a material supply, and a cumulative supply amount of the material from the quantity control unit 70 for a case where the cover body 60 having a cone shape tapering to the top of the cover body 60 is provided in the quantity control unit 70 and for a case where the cover body 60' having a cone shape tapering to the top of the cover body 60' with two-level inclinations is provided in the quantity control unit 70. Under the conditions of a measurement shown in the graph of Fig. 11, as depicted in Fig. 11, if the cover body 60' having two-level inclinations is provided in the quantity control unit 70, the cumulative supply amount of the material is increased in proportion to the supply time (that is, a regular amount of material may be supplied at any time). Meanwhile, if the cover body 60 having a typical cone shape with one level inclination is provided in the quantity control unit 70, the supply amount of the material is decreased in proportion to the time lapse. This may be because the organic material may remain/may be deposited at the upper surface (side surface) of the cover body 60 having the typical cone shape. The measurement shown in the graph of Fig. 11 may be carried out under certain conditions. Further, characteristic of a material supply may be different depending on a kind of an organic material or quantity control conditions. Therefore, desirably, a shape of the cover body 60 may be selected appropriately according to the conditions for controlling an amount of an organic material.

In the modified example shown in Fig. 10, there has been explained a case where the cover body 60' is formed in a cone shape tapering to the top of the cover body 60' with two-level inclinations. However, a shape of the cover body 60 may not be limited thereto. Therefore, Figs. 12(a) to 12(c) show other modified examples of the cover body 60, and shapes thereof will be explained below.

Figs. 12(a) to 12(c) are side views each showing a modified example of the cover body 60. As depicted in Fig. 12(a), in the cover body 60, a part (a periphery) of a cone shape tapering to the top of the cover body 60 may be removed and a cylinder-shaped member 105 may be provided under a cone-shaped member 104. Alternatively, as depicted in Fig. 12(b), in the cover body 60, vertical grooves 106 extending from a vertex portion of a cone shape tapering to the top of the cover body 60 toward a base portion may be provided at the side surface 101 of the cone shape. Further alternatively, as depicted in Fig. 12(c), the side surface 101 of the cover body 60 may be blast-processed. Still further alternatively, the cover body 60' having two-level inclinations depicted in Fig. 10 may have the vertical grooves 106 or may be blast-processed in either or both of the smoothly inclined surface 101a and the sharply inclined surface 101b.

In case of using the cover body 60 including the cone-shaped member 104 and the cylinder-shaped member 105 depicted in Fig. 12(a), the amount of an organic material remaining at the cover body 60 can be reduced and a falling efficiency of the material can be increased. In case of using the cover body 60 including the vertical grooves 106 depicted in Fig. 12(b), a quantity of an organic material at the cover body 60 can be controlled by varying the number or a width of the vertical grooves 106. As a result, stability of the falling efficiency of the organic material can be achieved. In case of using the cover body 60 whose side surface 101 is blast-processed as depicted in Fig. 12(c), since the side surface 101 is blast-processed, a kinetic energy due to a rotation of the cover body 60 may be transferred efficiently to the material remaining on the cover body 60, and the falling efficiency of the organic material can be increased.

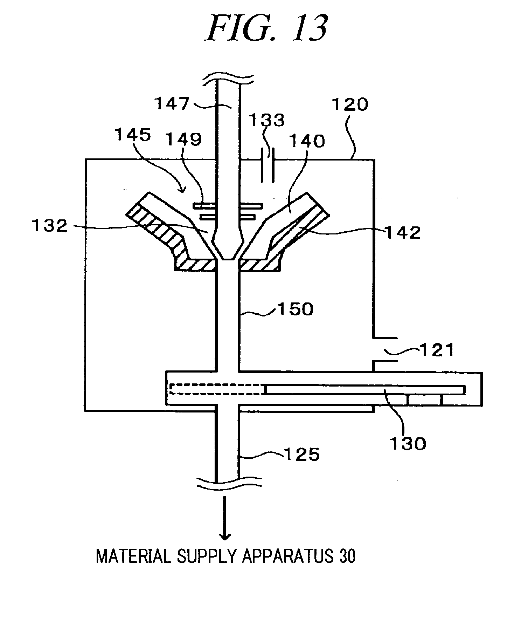

In the above-described embodiment, there has been explained that the material supply device 40 may be a load-lock type device. To be specific, the material supply device 40 may have a configuration to be explained below by reference to Fig. 13.

Fig. 13 is an explanatory diagram showing an example of the material supply device 40. As depicted in Fig. 13, the material supply device 40 may include a material receiving unit 120 configured to receive a material and a material supply path 125 configured to supply the material introduced by the material receiving unit 120 into the material supply apparatus 30. The material receiving unit 120 may be positioned above the material supply path 125. The material receiving unit 120 and the material supply path 125 may be connected to each other via a gate valve 130. The material receiving unit 120 can be sealed and the material receiving unit 120 may include an exhaust port 121. Thus, the material receiving unit 120 can be evacuated by an operation of a non-illustrated vacuum pump communicating with the exhaust port 121. The material supply path 125 may communicate with the mixing unit 42 of the material supply apparatus 30 which is not depicted in Fig. 13, and may be evacuated together with the mixing unit 42.

The material receiving unit 120 may include a refining device 140 formed in a shape (a bowl shape) surrounding a cone-shaped space 132 tapering to a bottom of the space 132 and a mixing device 145 configured to mix the cone-shaped space 132 within the refining device 140. In the material receiving unit 120, an openable/closeable inlet opening 133 configured to introduce the material to the space 132 within the refining device 140 may be provided. The mixing device 145 may include a rotation shaft 147 rotated by an operation of a non-illustrated driving device at a central portion of the space 132 and multiple mixing rods 149 horizontally provided at the rotation shaft 147. A bottom portion of the refining device 140 (lower portion of the space 132) may be connected to the gate valve 130 via a duct 150 through which a material refined by the refining device 140 passes. When the gate valve 130 is opened, the material falling down from the refining device 140 may pass through the duct 150 and may be introduced to the material supply path 125.

A heater 142 may be provided at an outer surface of the refining device 140 and a material introduced into the refining device 140 can be heated. Regarding installation and arrangement of heaters, desirably, the heater may be provided in various positions so as to maintain a temperature of the material at a certain level in the material supply device 40. Further, it is illustrated that a heater is not provided in other positions than the refining device 140. However, in order to efficiently and uniformly heat the material, desirably, the heater may be provided in other positions.

In accordance with the material supply device 40 configured as depicted in Fig. 13, while the gate valve 130 is closed, the material receiving unit 120 may be opened to atmosphere. The (organic) material may be introduced from the inlet opening 133 into the refining device 140 of the material receiving unit 120. Then, the introduced material may be heated and refined as the material is being mixed by the mixing rods 149 in the refining device 140.

Subsequently, the material receiving unit 120 may be evacuated by evacuation from the exhaust port 121. Herein, when the material supply apparatus 30 is operated, for example, the inside of the material supply apparatus 30, i.e. the mixing unit 42, depicted in Fig. 3, may be evacuated. When the gate valve 130 is opened in order to introduce the material, a vacuum level (internal pressure) in the material receiving unit 120 may need to be substantially the same as a vacuum level in the material supply path 125. Thus, the material receiving unit 120 may be evacuated to a vacuum level substantially the same as a vacuum level in the material supply apparatus 30.

After the material receiving unit 120 is evacuated, the gate valve 130 may be opened. Then, the material refined by the refining device 140 may pass through the duct 150, and may be introduced from the material supply path 125 into the mixing unit 42 of the material supply apparatus 30. Then, after the material is introduced into the material supply apparatus 30, the gate valve 130 may be closed and the material receiving unit 120 may be opened to atmosphere again. Thereafter, another material to be supplied may be refined.

The material supply device 40 depicted in Fig. 13 may be operated as described above and a material may be introduced into the material supply apparatus 30. Thus, another material can be introduced into the material supply apparatus 30 without any effect on a vacuum level (internal pressure) of the material supply apparatus 30, which is being operated in an evacuated state. Therefore, productivity can be improved.

In the vapor deposition apparatus 1, a refining device such as a vaporization refining device can be provided. Even if a vapor deposition process is performed with a material having a slightly low purity, the material may be refined by the refining device within the vapor deposition apparatus 1 before performing the vapor deposition process. Thus, a film of high quality can be formed. Although not illustrated in the above-described embodiment, desirably, a refining device may be provided, for example, within the mixing unit 42.

The above-described embodiment may not limit shapes of other various components. By way of example, in the above-described embodiment, there has been explained that the mixing member may be operated by rotation of a rotation shaft including a rod-shaped body. The present disclosure may not be limited to this embodiment. A wing-shaped flat plate may be provided at the rotation shaft.

### [Industrial Applicability]

The present disclosure can be applied to, for example, a vapor deposition apparatus and a vapor deposition method used for forming a light emitting layer in a manufacturing process of an organic EL device.

## Claims

1. A vapor deposition apparatus for forming a thin film on a substrate by vapor deposition, the apparatus comprising:
a depressurizable material supply apparatus configured to supply a material gas; and
a film forming apparatus configured to form a thin film on the substrate,
wherein the material supply apparatus comprises:
a quantity control unit configured to control a quantity of a material; and
a material gas generating unit configured to vaporize the material supplied from the quantity control unit.

2. The vapor deposition apparatus of claim 1, wherein the quantity control unit comprises:
a cover body having a cone shape tapering to a top of the cover body;
a cone-shaped concave body positioned so as to face a top surface of the cover body; and
a rotating device configured to rotate the cover body relative to the concave body.

3. The vapor deposition apparatus of claim 2, wherein a side surface of the cover body comprises an upper side surface and a lower side surface, and an inclination of the upper side surface is smaller than an inclination of the lower side surface.

4. The vapor deposition apparatus of claim 2, wherein the quantity control unit comprises:
an evacuable material supply device configured to supply the material into the quantity control unit; and
an elevating device configured to vary a gap between the cover body and the concave body.

5. The vapor deposition apparatus of claim 1, further comprising:
a vibrating device configured to vibrate the quantity control unit and a vicinity of the quantity control unit.

6. The vapor deposition apparatus of claim 1, wherein the material supply apparatus further comprises a mixing unit having a mixing member for mixing granular materials, and
the mixing unit is provided above the quantity control unit.

7. The vapor deposition apparatus of claim 1, wherein the material gas generation unit is configured as a material sublimating chamber for sublimating the material therein,
the material sublimating chamber communicates with the quantity control unit via a passage having a preset length,
the passage and the material sublimating chamber comprise a heater, and
a temperature of the passage at the side of the quantity control unit is lower than a temperature of the passage at the side of the material gas generation unit.

8. The vapor deposition apparatus of claim 7, wherein a sealed space accommodating the heater therein is formed at outer surfaces of the passage and the material sublimating chamber, and
a volatile liquid is provided within the sealed space.

9. The vapor deposition apparatus of claim 7, wherein the material sublimating chamber comprises:
a material dispersing plate for dispersing the material by allowing the material to pass therethrough; and
a material sublimating member, made of porous ceramic, having thereon a protrusion.

10. The vapor deposition apparatus of claim 7, wherein the material sublimating chamber comprises:
a material sublimating plate for sublimating the material by heating the material;
a rotatable shaft inserted through the inside of the passage; and
a material dispersing device fixed to an end of the shaft and positioned in a vicinity of a top surface of the material sublimating plate.

11. The vapor deposition apparatus of claim 7, wherein inner surfaces of the passage and the material sublimating chamber have roughness.

12. The vapor deposition apparatus of claim 1, wherein the material gas generation unit is configured as a material melting chamber for melting the material therein,
the material melting chamber communicates with the quantity control unit via a passage having a preset length,
the passage and the material melting chamber comprises a heater, and
a temperature of the passage at the side of the quantity control unit is lower than a temperature of the passage at the side of the material gas generation unit.

13. The vapor deposition apparatus of claim 12, wherein a sealed space accommodating the heater therein is formed at outer surfaces of the passage and the material melting chamber, and
a volatile liquid is provided within the sealed space.

14. The vapor deposition apparatus of claim 12, wherein inner surfaces of the passage and the material melting chamber have roughness.

15. The vapor deposition apparatus of claim 1, wherein the film forming apparatus comprises:
a processing chamber connected with an external vacuum pump;
a substrate holding chamber for holding a substrate therein; and
a vapor deposition head connected with the material gas generation unit via a material inlet path.

16. The vapor deposition apparatus of claim 15, wherein a valve for controlling a flow rate of the material is provided at the material inlet path,
a material retreating path, connected with the external vacuum pump and having an opening/closing valve provided at the material inlet path, and
a discharge path connected with the external vacuum pump, having an opening/closing vale provided at the vapor deposition head.

17. The vapor deposition apparatus of claim 4, wherein the material supply device comprises:
an evacuable material receiving unit configured to receive the material; and
a material supply unit configured to supply the introduced material into the material supply apparatus,
wherein the material receiving unit and the material supply unit are connected with each other via a gate valve.

18. The vapor deposition apparatus of claim 17, wherein the material receiving unit has a refining device for refining the material.

19. The vapor deposition apparatus of claim 1, wherein an argon gas as a carrier gas is introduced into the quantity control unit and the material gas generation unit.

20. A material supply apparatus for supplying a material gas into a film forming apparatus for forming a thin film on a substrate, the material supply apparatus comprising:
a quantity control unit configured to quantify a material; and
a material gas generating unit configured to vaporize the material supplied from the quantity control unit.

21. The material supply apparatus of claim 20, wherein the quantity control unit comprises:
a cover body having a cone shape tapering to a top of the cover body;
a cone-shaped concave body positioned so as to face a top surface of the cover body; and
a rotating device configured to rotate the cover body relative to the concave body.

22. The material supply apparatus of claim 20, wherein the quantity control unit comprises:
an evacuable material supply device configured to supply the material into the quantity control unit; and
an elevating device configured to vary a gap between the cover body and the concave body.

23. The material supply apparatus of claim 20, further comprising:
a vibrating device configured to vibrate the quantity control unit and a vicinity of the quantity control unit.

24. The material supply apparatus of claim 20, further comprising:
a mixing unit having a mixing member for mixing granular materials,
wherein the mixing unit is provided above the quantity control unit.

25. The material supply apparatus of claim 20, wherein the material gas generation unit is configured as a material sublimating chamber for sublimating the material therein,
the material sublimating chamber communicates with the quantity control unit via a passage having a preset length,
the passage and the material sublimating chamber comprise a heater, and
a temperature of the passage at the side of the quantity control unit is lower than a temperature of the passage at the side of the material gas generation unit.

26. The material supply apparatus of claim 25, wherein the material sublimating chamber comprises:
a material dispersing plate for dispersing the material by allowing the material to pass therethrough; and
a material sublimating member, made of porous ceramic, having thereon a protrusion.

27. The material supply apparatus of claim 25, wherein the material sublimating chamber comprises:
a material sublimating plate for sublimating the material by heating the material;
a rotatable shaft inserted through the inside of the passage; and
a material dispersing device fixed to an end of the shaft and positioned in a vicinity of a top surface of the material sublimating plate.

28. The material supply apparatus of claim 25, wherein inner surfaces of the passage and the material sublimating chamber have roughness.

29. The material supply apparatus of claim 20, wherein the material gas generation unit is configured as a material melting chamber for melting the material therein,
the material melting chamber communicates with the quantity control unit via a passage having a preset length,
the passage and the material melting chamber comprise a heater, and
a temperature of the passage at the side of the quantity control unit is lower than a temperature of the passage at the side of the material gas generation unit.

30. The material supply apparatus of claim 29, wherein inner surfaces of the passage and the material melting chamber have roughness.

31. A vapor deposition method for forming a thin film on a substrate by vapor deposition, the method comprising:
grinding a granular material;
vaporizing the ground material by sublimating or melting the ground material and vaporizing the melted material; and
forming a thin film on the substrate by using a gas of the vaporized material.

32. The vapor deposition method of claim 31, wherein the granular material is made by making a material in the form of powder into a material in the form of granule.
